# NEW EUROPEAN PATENT SPECIFICATION

(11) **EP 0 728 166 B2**
(45) Date of publication and mention of the opposition decision: **17.09.2008**
(45) Mention of the grant of the patent: 27.02.2002
(21) Application number: 95901221.2
(22) Date of filing: 10.11.1994
(51) Int. Cl.: C09J 133/00, C08F 220/18

(54) **PRESSURE SENSITIVE ADHESIVES**
DRUCKEMPFINDLICHE KLEBSTOFFE
ADHESIFS AUTOCOLLANTS

(30) Priority: 10.11.1993 US 150408; 10.11.1993 US 150425; 10.11.1993 US 150426
(43) Date of publication of application: 28.08.1996
(60) Divisional application: 00121649.8
(73) Proprietor: MINNESOTA MINING AND MANUFACTURING COMPANY, St. Paul, Minnesota 55133-3427 (US)
(72) Inventor: BENNETT, Greggory, S., Saint Paul, MN 55133-3427 (US); HAAK, Christopher, A., Saint Paul, MN 55133-3427 (US); GUSTAFSON, Craig, A., Saint Paul, MN 55133-3427 (US)
(74) Representative: Warcoin, Jacques
(86) International application number: PCT/US1994/012993
(87) International publication number: WO 1995/013331

(56) References cited:
- EP-A- 0 127 834
- EP-A- 0 194 881
- EP-A- 0 212 358
- EP-A- 0 258 573
- EP-A- 0 303 430
- EP-A- 0 351 193
- EP-A- 0 386 325
- EP-A- 0 395 990
- EP-A- 0 546 746
- EP-A- 0 625 557
- EP-B- 0 217 863
- WO-A-81/02262
- WO-A-92/01761
- WO-A-93/15333
- JP-A- 2 070 781
- JP-A- 4 298 586
- US-A- 3 491 070
- US-A- 4 316 830
- US-A- 4 525 363
- Polymer Engineering and Science, Feb. 1974, vol. 14, Nr. 2, pp. 147-154

## Description

This invention relates to pressure sensitive adhesives.

Acrylate pressure sensitive adhesives are well known in the art. Many of these adhesives are copolymers of an alkyl ester of acrylic acid and a minor portion of a polar co-monomer. Due to the presence of the polar co-monomer, these adhesives generally do not adhere well to low energy and oily surfaces (e.g., surfaces having a critical surface tension of wetting of no greater than about 35 dynes/cm). Although adhesion can be improved through addition of a tackifier, the degree of improvement is limited because most commercially available tackifiers are not miscible in the polar monomer-containing adhesive.

Among the background art, the applicant may cite the following documents:
WO-A-93 15333 (WILFONG) describes acrylate-epoxy blends in the form of interpenetrating networks useful as vibration damping materials. Wilfong also describes acrylate-only materials for this purpose. As set forth in Examples 8-13, such materials are either isobornyl acrylate homopolymers or copolymers of isobornyl acrylate and tetrahydrofurfuryl acrylate.
US 3 491 070 (WEAVER) describes emulsion-based adhesives that are terpolymers of 2-ethyl hexyl acrylate, N-octyl acrylamide and acrylamide or methacrylamide.
EP-A-0 546 746 (CRANDALL) describes an aqueous latex containing an emulsifier and a copolymer of an alkyl acrylate and an alkyl amide such as acrylamide.
EP-A-0 303 430 (MARTIN) describes adhesives prepared from one or more alkyl acrylates and, optionally, a strongly polar monomer and/or a moderately polar monomer.
WO-A-81 02262 (VESLEY) describes a photopolymerization process using triazine catalysts for preparing adhesives, e.g., copolymers of alkyl acrylates and acrylic acid.

The invention features a pressure sensitive adhesive comprising the reaction product of starting materials comprising:
(a) 25-97 parts by weight of an acrylic acid ester of a monohydric alcohol having 4-18 carbon atoms whose homopolymer has a Tg less than 0°C;
(b) 3-75 parts by weight of a non-polar ethylenically unsaturated monomer selected from the group consisting of 3,3,5 trimethylcyclohexyl acrylate, cyclohexyl acrylate, isobornyl acrylate, N-octyl acrylamide and combinations thereof;
(c) 0-5 parts by weight of a polar ethylenically unsaturated monomer selected from the group consisting of acrylic acid, itaconic acid, N,N dimethylacrylamide, N-vinyl-2-pyrrolidone, N-vinyl caprolactam, acrylonitrile, tetra-hydrofurfuryl acrylate, glycidyl acrylate, 2-phenoxyethylacrylate, benzylacrylate, and combinations thereof,
the relative amounts of said acrylic acid ester, said non-polar ethylenically unsaturated monomer, and said polar ethylenically unsaturated monomer being chosen such that the 90° peel adhesion of said reaction product to a polypropylene surface is at least 700 g/cm (21bs/0.5 in.) after a 72 hour dwell at room temperature as measured according to Test Procedure B-I.

In one preferred embodiment, the relative amounts of the acrylic acid ester, non-polar ethylenically unsaturated monomer, and polar ethylenically unsaturated monomer are chosen such that the 90° peel adhesion of the pressure sensitive adhesive to a polypropylene surface is at least 1 050 g/cm (3 lbs/0.5 in.) after a 72 hour dwell at room temperature as measured according to Test Procedure B-1.

The solubility parameter referred to herein is calculated according to the technique described in Fedors, *Polym. Eng. And Sci.,* **14**:147 (1974). A monomer whose homopolymer has a solubility parameter of greater than 10.50 when measured according to the Fedors technique is referred to herein as a polar monomer, whereas a monomer whose homopolymer has a solubility parameter of 10.50 or less when measured according to the Fedors technique is referred to herein as a non-polar monomer.

The invention provides pressure sensitive adhesives which, by virtue of incorporating a non-polar ethylenically unsaturated monomer selected from the group consisting of 3,3,5 trimethylcyclohexyl acrylate, cyclohexyl acrylate, isobornyl acrylate, N-octyl acrylamide and combinations thereof and limiting the polar monomer content selected from the group consisting of acrylic acid, itaconic acid, N,N dimethylacrylamide, N-vinyl-2-pyrrolidone, N-vinyl caprolactam, acrylonitrile, tetra-hydrofurfuryl acrylate, glycidyl acrylate, 2-phenoxyethylacrylate, benzylacrylate, and combinations thereof, to no more than 5 parts, exhibit good adhesion to low energy (e.g., plastics such as polyolefin plastics) surfaces. The adhesives exhibit good adhesion to high energy surfaces such as stainless steel as well.

The adhesives are less toxic than, e.g., adhesives containing polar heteroatom acrylates. The adhesives further exhibit good shear properties both at low and high temperatures, particularly when a small amount (no more than 5 parts) of a polar co-monomer is included.

The adhesives offer the further advantage of reduced sensitivity to moisture and reduced tendency to corrode metals such as copper relative to pressure sensitive adhesives containing higher amounts of polar co-monomers. Furthermore, the adhesives interact to a lesser extent with polar additives and, in some cases, increase the solubility of non-polar additives compared to pressure sensitive adhesives containing higher amounts of polar co-monomers.

Other features and advantages of the invention will be apparent from the following description of the preferred embodiments thereof, and from the claims.

One class of pressure sensitive adhesives according to this invention displays good adhesion to both low energy surfaces such as polypropylene and high energy surfaces such as stainless steel. In both cases, the 90 peel strength after a 72 hour dwell is at least 700 g/cm (2 lbs/0.5 in.), preferably at least 880g/cm (2.5 lbs/0.5 in.) and more preferably at least 1050 g/cm (3 lbs/0.5 in.) measured according to Test Procedure B-I, infra. The adhesives also display good cohesive strength properties as measured by the shear strength. Preferably, the shear strength at both room temperature and 70 C is greater than 50 minutes, more preferably greater than 1,000 minutes, and even more preferably greater than 10,000 minutes measured according to Test Procedure C-I, infra.

The properties of the pressure sensitive adhesives according to the invention are achieved by controlling the monomeric composition to achieve the appropriate polarity (as measured by the solubility parameter of the homopolymers of the individual monomers determined according to the Fedors technique) and rheological properties (Tg as measured by the 1 radian/second tan delta maximum temperature of the adhesive polymer).

A list of several common monomers and their respective Fedors' solubility parameters is shown in Table 1. Table 1 is subdivided into four sections: low Tg acrylate monomers, high T_{g} acrylate monomers, high Tg methacrylate monomers, and vinyl monomers.

**Table 1: Fedors' solubility parameters**

| Repeat unit | Solubility parameter |
|---|---|
| | (cal/cm³)^{0.5} |
| Octadecyl acrylate (ODA) | 8.99 |
| Lauryl acrylate (LA) | 9.15 |
| Iso-octyl acrylate (IOA) | 9.22 |
| 2-ethylhexyl acrylate (2-EHA) | 9.22 |
| Butyl acrylate (BA) | 9.77 |
| Propyl acrylate (PA) | 9.95 |
| Ethyl acrylate (EA) | 10.20 |
| 3,3,5 trimethylcyclohexyl acrylate (TMCA) | 9.35 |
| Iso-bornyl acrylate (IBA) | 9.71 |
| Cyclohexylacrylate (CHA) | 10.16 |
| N-octyl acrylamide (NOA) | 10.33 |
| Tetrahydrofurfuryl acrylate (THFA) | 10.53 |
| Methyl acrylate (MA) | 10.56 |
| Glycidyl acrylate (GA) | 11.32 |
| 2-phenoxyethylacrylate (2-PhEA) | 11.79 |
| N-vinylcaprolactam (NVC) | 12.10 |
| N,N,-dimethylacrylamide (NVP) | 12.32 |
| N-vinyl-2-pyrrolidone (NVP) | 13.38 |
| Acrylic acid (AA) | 14.04 |
| Methylmethacrylate (MMA) | 9.93 |
| Ethylmethacrylate (EMA) | 9.72 |
| Propylmethacrylate (PMA) | 9.57 |
| Vinyl acetate | 10.56 |
| styrene | 11.87 |

The rheological character of the adhesive polymer can be partially but usefully described by the Tg as measured by the 1 radian/second tan delta maximum temperature. In the case of adhesives designed for adhesion to low energy surfaces, it is preferable for the Tg as measured by the 1 radian/second tan delta maximum of the polymer to have a value between -45 and 15°C, more preferably between -25 and 0°C, and even more preferably between -20 and -5°C.

Adhesives according to the invention having the requisite polarity and rheological properties contain 25-98 parts (more preferably 70-97 parts) of an acrylic acid ester whose homopolymer has a T_{g} less than 0°C (more preferably less than -20°C), 2-75 parts (more preferably 3-30 parts) of a non-polar ethylenically unsaturated monomer whose homopolymer has a T_{g} greater than 15°C, 0-5 parts (more preferably 0-3 parts) of a polar ethylenically unsaturated monomer whose homopolymer has a T_{g} greater than 15°C.

The acrylic acid ester is a monofunctional acrylic ester of a monohydric alcohol having from about 4 to 18 carbon atoms in the alcohol moiety whose homopolymer has a Tg less than 0°C. Included in this class of acrylic acid esters are isooctyl acrylate, 2-ethylhexyl acrylate, isononyl acrylate, isodecyl acrylate, decyl acrylate, lauryl acrylate, hexyl acrylate, butyl acrylate, and octadecyl acrylate, or combinations thereof. In the case of octadecyl acrylate, the amount is chosen such that side chain crystallization does not occur at room temperature.

The non-polar ethylenically unsaturated monomer is a monomer whose homopolymer has a solubility parameter as measured by the Fedors method of not greater that 10.50 and a T_{g} greater than 15°C. The non-polar nature of this monomer improves the low energy surface adhesion and oily surface adhesion of the adhesive. It also improves the structural properties of the adhesive (e.g., cohesive strength) relative to a homopolymer of the acrylic acid ester described above. The suitable non-polar monomers are selected from 3,3,5-trimethylcyclohexyl acrylate, cyclohexyl acrylate, isobornyl acrylate, N-octyl acrylamide and combinations thereof.

The adhesive may contain a limited quantity (e.g., no more than 5 parts) of a polar ethylenically unsaturated monomer whose homopolymer has a solubility parameter as measured by the Fedors method of greater than 10.50 and a Tg greater than 15°C to improve structural properties (e.g., cohesive strength). It is not desirable to include more than 5 parts of the polar monomer because the polar monomer impairs low energy surface adhesion and oily surface adhesion, and reduces tackifier miscibility. The suitable polar monomers are selected from acrylic acid, itaconic acid, certain substituted acrylamides such as N,N dimethylacrilamide, N-vinyl-2-pyrrolidone, N-vinyl caprolactam, acrylonitrile, tetrahydrofurfuryl, glycidyl acrylate, 2-phenoxyethylacrylate, and benzylacrylate, or combinations thereof.

The monomer mixture can be polymerised by various techniques, with photoinitiated bulk polymerization being preferred. An initiator is preferably added to aid in polymerization of the monomers. The type of initiator used depends on the polymerization process. Photoinitiators which are useful for polymerizing the acrylate monomers include benzoin ethers such as benzoin methyl ether or benzoin isopropyl ether, substituted benzoin ethers such as 2-methyl-2-hydroxylpropiophenone, aromatic sulfonyl chlorides such as 2-naphtalenesulfonyl chloride, and photoactive oxides such as 1-phenyl-1,2-propanedione-2-(o-ethoxycarbonyl)oxime. An example of commercially available photoinitiator is Irgacure^{™} 651 available from Ciba-Geigy Corporation, having the formula 2,2-dimethoxy-1,2-diphenylethane-1-one. Generally, the photoinitiator is present in an amount of about 0.005 to 1 weight percent based on the weight of the monomers. Examples of suitable thermal initiators include AIBN and peroxides.

The mixture of the polymerizable monomers may also contain a crosslinking agent, or a combination of crosslinking agents, to increase the shear strength of the adhesive. Useful crosslinking agents include substituted triazines such as 2,4,-bis(trichloromethyl)-6-(4-methoxy phenyl)-s-triazine, 2,4-bis (trichloromethyl)-6-(3,4-dimethoxyphenyl)-s-triazine, and the chromophore-substituted halo-s-triazines disclosed in US patents n° 4329 384 and 4 330 590 (VESLEY). Other useful crosslinking agents include multifunctional alkyl acrylate monomers such as trimetholpropane triacrylate, pentaerythritol tetra-acrylate, 1,2-ethylene glycol diacrylate, 1,4-butanediol diacrylate, 1,6-hexanediol diacrylate and 1,12-dodecanol diacrylate. Various other crosslinking agents with different molecular weights between (meth)acrylate functionality would also be useful. Generally, the crosslinker is present in an amount of about 0.005 to 1 weight percent based on the combined weight of the monomers.

Where a foam-like pressure sensitive adhesive tape is desired, a monomer blend containing microspheres may be used. Suitable microspheres are commercially available from Kema Nord Plastics under the trade name "Expancel" and from Matsumoto Yushi Seiyaku under the trade name "Micropearl". When expanded the microspheres have a specific density of approximately 0.02-0.036 g/cc. It is possible to include the unexpanded microspheres in the pressure sensitive adhesive composition and subsequently heat them to cause expansion when they are appropriately processed, but it is generally preferred to mix the expanded microspheres into the adhesive. This process makes it easier to ensure that the hollow microspheres in the final adhesive are substantially surrounded by at least a thin layer of adhesive.

Polymeric microspheres having an average diameter of 10 to 200 micrometers may be blended into the polymerizable composition in amounts from about 15% to about 75% by volume prior to coating. Also useful are glass microspheres having an average diameter of from 5 to 200 micrometers, preferably from about 20 to 80 micrometers. Such microspheres may comprise 5% to 65% by volume of the pressure sensitive adhesive. Both polymeric and glass microspheres are known in the art. The pressure sensitive adhesive layer of the tape should be at least 3 times as thick as the diameter of the microspheres, preferably at least 7 times.

Other tape constructions in which the pressure sensitive adhesives according to the invention are useful include mechanical fasteners such as Dual-Lock^{™} brand fastener (Minnesota Mining and manufacturing Co., St Paul, MN) and Scotchmate^{™} brand fastener (Minnesota Mining and manufacturing Co., St Paul, MN). The pressure sensitive adhesives are also useful in vibration damping applications.

Other materials which can be blended with the polymerizable monomers prior to coating include plasticizers, tackifiers, coloring agents, reinforcing agents, fire retardants, foaming agents, thermally condictive agents, electrically conductive agents, post-curing agents, and post-curing agent curatives and their accelerators, and the like.

The pressure sensitive adhesives according to the invention are preferably prepared by photoinitiated bulk polymerization according to the technique described in Martens et *al*., US patent n° 4 181 752. The polymerizable monomers and a photinitiator are mixed together in the absence of solvent and partially polymerized to a viscosity in the range of from about 0.5 Pa.s (500 cps) to about 50 Pa.s (50 000 cps) to achieve a coatable syrup. Alternatively, the monomers may be mixed with a thixotropic agent such as fumed hydrophilic silica to achieve a coatable thickness. The crosslinking agent and any other ingredients (including any tackifiers) are then added to the prepolymerized syrup. Alternatively, these ingredients (including any tackifiers but with the exception of the crosslinking agent) can be added directly to the monomer mixture prior to prepolymerization.

The resulting composition is coated onto a substrate (which may be transparent to ultraviolet radiation) and polymerized in an inert (i.e., oxygen free) atmosphere, e.g., a nitrogen atmosphere by exposure to ultraviolet radiation. Examples of suitable substrates include release liners (e.g., silicone release liners) and tape backings (which may be primed or unprimed paper or plastic). A sufficiently inert atmosphere can also be achieved by covering a layer of the polymerizable coating with a plastic film which is substantially transparent to ultraviolet radiation, and irradiating through that film in air as described in the aforementioned Martens *et al.* patent using ultraviolet lamps. Alternatively, instead of covering the polymerizable coating, an oxidizable tin compound may be added to the polymerizable syrup to increase the tolerance of the syrup to oxygen as described in the US patent n° 4 303 485 (LEVENS). The ultraviolet light source preferably has 90% of the emissions between 280 and 400 nm (more preferably between 300 and 400nm), with a maximum at 351 nm.

Tackifiers may also be added after polymerization of the acrylate monomers.

Where multi-layer tape constructions are desirable, one method of construction is multi-layer coating using conventional techniques. For example, the coatings may be applied concurrently (e.g., through a die coater), after which the entire multi-layer structure is cured all at one. The coatings may also be applied sequentially whereby each individual layer is partially or completely cured prior to application of the next layer.

The invention will now be further described by way of the following examples.

### Test Procedures-Low Energy Surface Adhesion Adhesives

Tests procedures used in the examples to evaluate tackified pressure sensitive adhesives include the following.

### Monomer Conversion Test (Test Procedure A1)

The monomer conversion was determined gravimetrically. A sample of the adhesive was weighed after it was coated and subsequently dried at 120°C for 3 hours and then re-weighed. The percent volatile was taken to be indicative of the monomer conversion.

### 90 Peel Adhesion Test (Test Procedure B-I)

One-half inch wide strips of the adhesive sample were carefully cut and placed onto the substrate of interest. The adhesive thickness was 0.0127 cm (5 mils). A 0.0127 (5 mil) anodized aluminium backing (1.59 cm (0.625 in, wide)) was then laminated to the adhesive which is approximately 1.27 cm (5 inches) long. Test substrates of interest included low energy surfaces such as polypropylene 5.08 cm x12.7 cm x 0.48cm (2" x 5" x 3/16") natural polypropylene panels from Precision Punch and Plastic, Minneapolis, MN, with a mask on both sides that is removed prior to cleaning and testing) and polycarbonate(Lexan^{™} from General Electric Co.), and high energy surfaces such as stainless steel (304-2BA 28 gauge stainless steel with a surface roughness of 5.08 x 10⁻² microns (2.0 ± 1.0 microinches). A free end of the backing to which the adhesive was laminated extended beyond the test substrate so that it could be clamped to a load cell to determine peel strength.

The sample was rolled back and forth twice with a 2 kg hard rubber roller to ensure contact between the adhesive and the test substrate. The adhesive was then removed after a given dwell time (usually 72 hours unless otherwise noted) at 30.5 cm/min (12"/minute) in a 90° peel mode. The stainless steel substrates were washed once with acetone and 3 times with a 50/50 isopropanol/water mixture prior to testing. The plastic substrates were washed 3 times with heptane prior to testing. The results are reported in 350g/cm (lbs/0.5 in.) width as the average of 2 tests. All tests were conducted at room temperature.

### Shear Test (Test Procedure C1)

A 1.27 cm (0.5 inch) strip of tape was adhered to a piece of stainless steel (304 stainless steel with a surface roughness of 5.08 x10⁻² microns ± 2.54 x 10⁻² 2.0 ± 1.0 micro-inch)) which had been cleaned once with acetone and 3 times with 50/50 isopropanol/water such that a one-half square inch overlap was accomplished. A piece of 0.0127 cm (5 mil) anodized aluminum (1.59 cm (0.625 in.) wide) was then laminated to the entire area of the pressure sensitive adhesive, leaving an additional area to which a load could be applied. The thickness of the adhesive was 0.0127 cm (5 mils). The sample was then rolled twice back and forth with a 6 675 g (15 pound) roller and allowed to dwell for four hours. The 70°C samples were further allowed to dwell for 10 minutes at 70°C. After dwelling, the sample was tested at either room temperature or 70°C. At room temperature a 1 kg load was applied to the adhesive and the time before the load fell was recorded. At 70°C a 500 g load was applied to the adhesive and the time before the load fell was recorded.

The results are reported as the average of two tests.

### Comparative Examples-Low Energy Surface Adhesion

### Comparative Example C1

A premix was prepared using 90 parts isooctyl acrylate (IOA), 10 parts acrylic acid (AA), and 0.04 parts 2,2-dimethoxy-2-phenylacetophenone photoinitiator (Irgacure TM 651, available from Ciba Geigy Corp.) This mixture was partially polymerized under a nitrogen-rich atmosphere by exposure to ultraviolet radiation to provide a coatable syrup having a viscosity of about 3 PA;s (3000 cps). 0.15 parts of 2,6-bistrichloromethyl-6- (4-methoxphenyl)-s-triazine and an additional 0.16 parts of Irgacure^{™} 651 were added to the syrup and it was then knife coated onto a silicone treated polyethylene-coated paper release liner at a thickness of 0.0127 cm (5 mils). The resulting composite was then exposed to ultraviolet radiation having a spectral output from 300-400 nm with at maximum at 351 nm in a nitrogen-rich environment. An intensity of about 1.0 mW/cm² was used for the first one-third of the exposure time and an intensity of about 2.2 mW/cm² was used for the second two-thirds of exposure time, resulting in a total energy of 250 mJ/cm². The adhesive was then tested according to the test methods listed above and the results are shown in Table 1-2. The designation "RT" means room temperature.

### Comparative Examples C2 and C3

Comparative example C2 was prepared in the same way as comparative example C1 except that a premix of 94 parts of IOA and 6 parts of AA was used.
Comparative example C3 was prepared in the same way as comparative example C1 except that a premix of 100 parts of IOA and 0 parts of AA was used. Comparative examples C2 and C3 were tested according to the test methods listed above and the results are shown in Table 1-2.

**TABLE I-2:**

| Ex. | stainless steel peel strengh | Polypropylene peel strengh | R.T. shear (minutes) | 70° shear (minutes) | Percent conversion |
|---|---|---|---|---|---|
| C1 | (5.33)1865 | (0.43)150 | 10,000+ | 10,000+ | >98.5% |
| C2 | (3.73)1305 | (1.29)451 | 10,000+ | 10,000+ | >98.5% |
| C3 | (1.35)472 | (1.53)535 | 2 | 3 | >98.5% |

### Examples-Low Energy Surface Adhesion

### Examples 1-23:

Example 1 was prepared in the same way as comparative example C1 except the premix consisted of 66 parts IOA, 33.5 parts isobornyl acrylate (IBA), and 0.5 parts of AA. In addition, 0.09 parts of 2,6-bistrichloromethyl-6-(4-methoxyphenyl)-s-triazine were added after the premix was partially polymerized. The composite was exposed to ultraviolet radiation having a spectral output from 300-400 nm with at maximum at 351 nm in a nitrogen-rich environment at an average intensity of about 2.05 mW/cm². The total energy was 650mJ/cm².

Example 2 was prepared in the same way as Example 1 except a premix consisting of 69 parts IOA, 30 parts IBA, and 1 part AA was used.

Example 3 was prepared in the same way Example 1 except a premix consisting of 65.5 parts IOA, 34.25 parts IBA, and 0.25 parts AA was used.

Example 4 was prepared in the same way as Example 1 except a premix consisting of 65 parts IOA and 35 parts IBA was used and 0.05 parts of 2,5-bistrichloromethyl-6-(4-methoxyphenyl)-s-triazine was used.

Example 5 was prepared in the same way as Example 4 except a premix of 55 parts IOA and 45 parts (3,3,5trimethylcyclohexyl acrylate (TMCA) was used.

Example 6 was prepared in the same way as Example 5 except 0.10 parts of 2,6-bis-trichloromethyl-4-(pmethoxyphenyl) -s-triazine was used.

Example 7 was prepared in the same way as Example 1 except a premix of 72 parts of IOA, 27 parts of IBA, and 1 part of AA was used.

Example 8 was prepared in the same way as Example 1 except a premix of 66 parts of IOA, 33 parts of IBA, and 1 part of AA was used.

Example 9 was prepared in the same way as Example 1 except a premix of 63 parts of IOA, 36 parts of IBA, and 1 part of AA was used.

Example 10 was prepared in the same way as Example 1 except a premix of 70.75 parts of IOA, 29 parts of TMCA, and 0.25 parts of AA was used.

Example 11 was prepared in the same way as Example 1 except a premix of 64.5 parts of IOA, 35 parts of TMCA, and 0.5 parts of AA was used.

Example 12 was prepared in the same way as Example 1 except a premix of 49 parts of IOA, 51.5 parts of cyclohexyl acrylate (CHA), and 0.5 parts of AA was used.

Example 13 was prepared in the same way as Example 1 except a premix of 80 parts of IOA, 19.5 parts of Noctylacrylamide (NOA), and 0.5 parts of AA was used.

Example 14 was prepared in the same way as Example 6 except a premix of 90 parts IOA, 10 parts IBA, and 0.5 parts AA was used.

Example 15 was prepared in the same way as Example 6 except a premix of 80 parts IOA, 20 parts IBA, and 0.5 parts AA was used.

Example 16 was prepared in the same way as Example 6 except a premix of 70 parts IOA, 30 parts IBA, and 0.5 parts AA was used.

Example 17 was prepared in the same way as Example 6 except a premix of 90 parts IOA, 10 parts TMCA, and 0.5 parts AA was used.

Example 18 was prepared in the same way as Example 6 except a premix of 80 parts IOA, 20 parts TMCA, and 0.5 parts AA was used.

Example 19 was prepared in the same way as Example 6 except a premix of 70 parts IOA, 30 parts TMCA, and 0.5 parts AA was used.

Example 20 was prepared in the same way as Example 6 except a premix of 60 parts IOA, 40 parts TMCA, and 0.5 parts AA was used.

Example 21 was prepared in the same way as Example 6 except a premix of 55 parts IOA, 45 parts TMCA, and 0.5 parts AA was used.

Example 22 was prepared in the same way as Example 6 except a premix of 50 parts IOA, 50 parts CHA, and 0.5 parts AA was used.

Example 23 was prepared in the same way as Example 6 except a premix of 45 parts IOA, 55 parts CHA, and 0.5 parts AA was used.

The data of Examples 1-23 are shown in Table 1-3.

In said table "St. St." refers to stainless steel. The designation "n.t." means not tested. The designation "RT" means room temperature. The designation "(1/2)" means that 1 of the 2 samples tested passed' the test.

The samples for peel testing in Examples 4 and 5 were prepared using a 6 675 g (15 1b) roller. A 24 hr. dwell period was used. Because Examples 13, 14, 17, 18, 22, and 23 do not meet the minimum peel adhesion requirement, they are included here as further comparative examples.

**Table I-3:**

| Ex. | St.St | Polyprop. | Polycarb. | RT shear | 70°C shear | % conv. |
|---|---|---|---|---|---|---|
| 1 | 1085(3.10) | 1088(3.11) | 1725(4.93) | 10K+ | 10K+ | >98.5% |
| 2 | 1169(3.34) | 917(2.62) | 1501(4.29) | 10K+ | 10K+ | >98.5% |
| 3 | 11935(3.41) | 1172(3.35) | 1537(4.39) | 10K+ | 10K+ | >98.5% |
| 4 | 1225(3.50) | 980(2.80) | 1683(4.81) | 1409 | 51 | >98.5% |
| 5 | 10(3.08) | 959(2.74) | nt | 2960 | 143 | >98.5% |
| 6 | 1127(3.22) | 858(2.45) | 1470(4.20) | 1138 | 324 | >98.5% |
| 7 | 1148(3.28) | 868(2.48) | nt | 10K+ | 10K+ | >98.5% |
| 8 | 1123(3.21) | 714(2.04) | nt | 10K+ | 10K+ | >98.5% |
| 9 | 1099(3.14) | 742(2.12) | nt | 10K+ | 10K+ | >98.5% |
| 10 | 1113(3.18) | 850(2.43) | nt | 3375 | 10K+ | >98.5% |
| 11 | 837(2.39) | 728(2.08) | 1022(2.92) | 10K+ | 10K+ | >98.5% |
| 12 | 1246(3.56) | 882(2.52) | 1288(3.68) | 3960 | 10K+ | >98.5% |
| 13 | 735(2.10) | 599(1.71) | 913(2.61) | 2334 | 10K+ | >98.5% |
| 14 | 521(1.49) | 550(1.57) | nt | 1207 | 10K+(1/2) | >98.5% |
| 15 | 644(1.84) | 648(1.85) | nt | 3133 | 10K+ | >98.5% |
| 16 | 780(2.23) | 798(2.28) | nt | 10K+(1/2) | 2058 | >98.5% |
| 17 | 578(1.65) | 654(1.87) | nt | 1103 | 10K+ | >98.5% |
| 18 | 578(1.65) | 661(1.89) | nt | 3747 | 10K+ | >98.5% |
| 19 | 661(1.89) | 756(2.16) | nt | 10K+(1/2) | 10K+ | >98.5% |
| 20 | 809(2.31) | 843(2.41) | nt | 10K+ | 10K+ | >98.5% |
| 21 | 665(1.90) | 942(2.69) | nt | 10K+ | 10K+ | >98.5% |
| 22 | 1004(2.87) | 413(1.18) | nt | 10K+ | 10K+ | >98.5% |
| 23 | 1235(3.53) | 333(0.95) | nt | 10K+ | 10K+ | >98.5% |

The data of Table 1-3 shows that the adhesion to low energy surfaces like polypropylene can be increased without decreasing the adhesion to high energy surface such as stainless steel as was observed in the comparative examples of Table 1-2. In addition the data of Table 1-3 shows that desirable cohesive strength properties can also be achieved in the pressure sensitive adhesives of this invention.

## Claims

1. A pressure sensitive adhesive comprising the reaction product of starting materials comprising:
(a) 25-97 parts by weight of an acrylic acid ester of a monohydric alcohol having 4-18 carbon atoms whose homopolymer has a Tg less than 0°C;
(b) 3-75 parts by weight of a non-polar ethylenically unsaturated monomer selected from the group consisting of 3,3,5 trimethylcyclohexyl acrylate, cyclohexyl acrylate, isobornyl acrylate, N-octyl acrylamide, and combinations thereof;
(c) 0-5 parts by weight of a polar ethylenically unsaturated monomer selected from the group consisting of acrylic acid, itaconic acid, N,N dimethylacrylamide, N-vinyl-2-pyrrolidone, N-vinyl caprolactam, acrylonitrile, tetra-hydrofurfuryl acrylate, glycidyl acrylate, 2-phenoxyethylacrylate, benzylacrylate, and combinations thereof,
the relative amounts of said acrylic acid ester, said non-polar ethylenically unsaturated monomer, and said polar ethylenically unsaturated monomer being chosen such that the 90° peel adhesion of said reaction product to a polypropylene surface is at least 700 g/cm (21bs/0.5 in.) after a 72 hour dwell at room temperature as measured according to Test Procedure B-I.

2. The pressure sensitive adhesive of claim 1, wherein the relative amounts of said acrylic acid ester, said non-polar ethylenically unsaturated monomer, and said polar ethylenically unsaturated monomer are chosen such that the 90° peel adhesion of said reaction product to a polypropylene surface is at least 1 050 g/cm (3 lbs/0.5 in.) after a 72 hour dwell at room temperature as measured according to Test Procedure B-I.

3. The pressure sensitive adhesive of claim 1, comprising 40-85 parts by weight of said acrylic acid ester.

4. The pressure sensitive adhesive of claim 1, comprising 15-60 parts by weight of said non-polar ethylenically unsaturated monomer.

5. The pressure sensitive adhesive of claim 1, wherein the acrylic acid ester is selected from the group consisting of isooctyl acrylate, 2-ethyl hexyl acrylate, isononyl acrylate, isodecyl acrylate, decyl acrylate, lauryl acrylate, hexyl acrylate, butyl acrylate, octadecyl acrylate, and combinations thereof.

6. The pressure sensitive adhesive of claim 1, wherein said a non-polar ethylenically unsaturated monomer is isobornyl acrylate.

7. The pressure sensitive adhesive of claim 1, comprising the reaction product of isooctyl acrylate, isobornyl acrylate and acrylic acid.

8. The pressure sensitive adhesive of claim 1, comprising the reaction product of isooctyl acrylate and isobornyl acrylate.

9. The pressure sensitive adhesive of claim 1, further comprising a crosslinking agent, and optionally, one or more additives selected from the group consisting essentially microspheres, plasticizers, tackifiers, coloring agents, reinforcing agents, fire retardants, foaming agents, thermally conductive agents, electrically conductive agents, post-curing agents, accelerators, and combinations thereof.

10. The use of pressure sensitive adhesive according to anyone of claims 1 to 9 to provide vibration damping articles.

## Patentansprüche

1. Haftkleber, umfassend das Reaktionsprodukt von Ausgangsmaterialien, welche umfassen:
(a) 25 bis 97 Gewichtsteile eines Acrylsäureesters eines einwertigen Alkohols mit 4 bis 18 Kohlenstoffatomen, dessen Homopolymer eine T_{g} von weniger als 0°C aufweist;
(b) 3 bis 75 Gewichtsteile eines nichtpolaren ethylenisch ungesättigten Monomers, ausgewählt aus 3,3,5-Trimethylcyclohexylacrylat, Cyclohexylacrylat, Isobornylacrylat, N-Octylacrylamid und Kombinationen davon;
(c) 0 bis 5 Gewichtsteile eines polaren ethylenisch ungesättigten Monomers, ausgewählt aus Acrylsäure, Itaconsäure, N,N-Dimethylacrylamid, N-Vinyl-2-pyrrolidon, N-Vinylcaprolactam, Acrylnitril, Tetrahydrofurfurylacrylat, Glycidylacrylat, 2-Phenoxyethylacrylat, Benzylacrylat und Kombinationen davon,
wobei die relativen Mengen des Acrylsäureesters, des nichtpolaren ethylenisch ungesättigten Monomers und des polaren ethylenisch ungesättigten Monomers so gewählt sind, dass die 90°-Abziehhaftung des Reaktionsprodukts an einer Polypropylen-Oberfläche nach 72-stündiger Verweilzeit bei Raumtemperatur, gemessen nach Testverfahren B-I, mindestens 700 g/cm (2 lbs/0,5 inch) beträgt.

2. Haftkleber nach Anspruch 1, wobei die relativen Mengen des Acrylsäureesters, des nichtpolaren ethylenisch ungesättigten Monomers und des polaren ethylenisch ungesättigten Monomers so gewählt sind, dass die 90°-Abziehhaftung des Reaktionsprodukts an einer Polypropylen-Oberfläche nach 72-stündiger Verweilzeit bei Raumtemperatur, gemessen nach Testverfahren B-I, mindestens 1050 g/cm (3 lbs/0,5 inch) beträgt.

3. Haftkleber nach Anspruch 1, umfassend 40 bis 85 Gewichtsteile des Acrylsäureesters.

4. Haftkleber nach Anspruch 1, umfassend 15 bis 60 Gewichtsteile des nichtpolaren ethylenisch ungesättigten Monomers.

5. Haftkleber nach Anspruch 1, wobei der Acrylsäureester aus Isooctylacrylat, 2-Ethylhexylacrylat, Isononylacrylat, Isodecylacrylat, Decylacrylat, Laurylacrylat, Hexylacrylat, Butylacrylat, Octadecylacrylat und Kombinationen davon ausgewählt ist.

6. Haftkleber nach Anspruch 1, wobei das nichtpolare ethylenisch ungesättigte Monomer Isobornylacrylat ist.

7. Haftkleber nach Anspruch 1, umfassend das Reaktionsprodukt von Isooctylacrylat, Isobornylacrylat und Acrylsäure.

8. Haftkleber nach Anspruch 1, umfassend das Reaktionsprodukt von Isooctylacrylat und Isobornylacrylat.

9. Haftkleber nach Anspruch 1, weiter umfassend ein Vernetzungsmittel und gegebenenfalls mindestens ein Additiv, ausgewählt im Wesentlichen aus Mikrokügelchen, Weichmachern, Klebrigmachern, Färbemitteln, Verstärkungsmitteln, Flammverzögerungsmitteln, Schaumbildnern, thermisch leitfähigen Mitteln, elektrisch leitfähigen Mitteln, Nachhärtemitteln, Beschleunigern und Kombinationen davon.

10. Verwendung eines Haftklebers nach einem der Ansprüche 1 bis 9 zur Bereitstellung von schwingungsdämpfenden Gegenständen.

## Revendications

1. Adhésif sensible à la pression comprenant le produit de la réaction de matériaux de départ comprenant :
(a) 25 à 97 parties en poids d'un ester d'acide acrylique d'un alcool monohydrique ayant de 4 à 18 atomes de carbone dont l'homopolymère a une Tg inférieure à 0°C ;
(b) 3 à 75 parties en poids d'un monomère à insaturation éthylénique non polaire choisi dans le groupe constitué par l'acrylate de 3,3,5-triméthylcyclohexyle, l'acrylate de cyclohexyle, l'acrylate d'isobornyle, le N-octylacrylamide, et leurs combinaisons ;
(c) 0 à 5 parties en poids d'un monomère à insaturation éthylénique polaire choisi dans le groupe constitué par l'acide acrylique, l'acide itaconique, le N,N-diméthylacrylamide, la N-vinyl-2-pyrrolidone, le N-vinylcaprolactame, l'acrylonitrile, l'acrylate de tétrahydrofurfuryle, l'acrylate de glycidyle, l'acrylate de 2-phénoxyéthyle, l'acrylate de benzyle, et leurs combinaisons,
les quantités relatives dudit ester d'acide acrylique, dudit monomère à insaturation éthylénique non polaire, et dudit monomère à insaturation éthylénique polaire étant choisies de façon que l'adhérence au pelage à 90° dudit produit réactionnel sur une surface en polypropylène soit d'au moins 700 g/cm (2 livres/0,5 pouce) après 72 heures de pause à la température ambiante, telle que mesurée conformément à la Procédure de Test B-I.

2. Adhésif sensible à la pression selon la revendication 1, dans lequel les quantités relatives dudit ester d'acide acrylique, dudit monomère à insaturation éthylénique non polaire, et dudit monomère à insaturation éthylénique polaire sont choisies de façon que l'adhérence au pelage à 90° dudit produit réactionnel sur une surface en polypropylène soit d'au moins 1050 g/cm (3 livres/0,5 pouce) après 72 heures de pause à la température ambiante, telle que mesurée conformément à la Procédure de Test B-I.

3. Adhésif sensible à la pression selon la revendication 1, comprenant 40 à 85 parties en poids dudit ester d'acide acrylique.

4. Adhésif sensible à la pression selon la revendication 1, comprenant 15 à 60 parties en poids dudit monomère à insaturation éthylénique non polaire.

5. Adhésif sensible à la pression selon la revendication 1, dans lequel l'ester d'acide acrylique est choisi dans le groupe constitué par l'acrylate d'isooctyle, l'acrylate de 2-éthylhexyle, l'acrylate d'isononyle, l'acrylate d'isodécyle, l'acrylate de décyle, l'acrylate de lauryle, l'acrylate d'hexyle, l'acrylate de butyle, l'acrylate d'octadécyle, et leurs combinaisons.

6. Adhésif sensible à la pression selon la revendication 1, dans lequel ledit monomère à insaturation éthylénique non polaire est l'acrylate d'isobornyle.

7. Adhésif sensible à la pression selon la revendication 1, comprenant le produit de la réaction d'acrylate d'isooctyle, d'acrylate d'isobornyle et d'acide acrylique.

8. Adhésif sensible à la pression selon la revendication 1, comprenant le produit de la réaction d'acrylate d'isooctyle et d'acrylate d'isobornyle.

9. Adhésif sensible à la pression selon la revendication 1, comprenant en outre un agent de réticulation, et éventuellement un ou plusieurs additifs choisis dans le groupe constitué essentiellement par les microsphères, les plastifiants, les agents de pégosité, les agents colorants, les agents de renforcement, les agents ignifugeants, les agents moussants, les agents thermiquement conducteurs, les agents électriquement conducteurs, les agents de post-durcissement, les accélérateurs, et leurs combinaisons.

10. Utilisation de l'adhésif sensible à la pression selon l'une quelconque des revendications 1 à 9 pour former des articles amortissant les vibrations.
